# EUROPEAN PATENT SPECIFICATION

(11) **EP 2 634 294 B1**
(45) Date of publication and mention of the grant of the patent: **29.04.2020**
(21) Application number: 11836064.3
(22) Date of filing: 17.10.2011
(51) Int. Cl.: C30B 29/38, C23C 16/01, C23C 16/34, C30B 25/20, H01L 21/205, H01L 33/32, C23C 16/30, C30B 25/02, C30B 29/40, H01L 33/00

(54) **METHOD FOR MANUFACTURING OPTICAL ELEMENT AND OPTICAL ELEMENT MULTILAYER BODY**
VERFAHREN ZUR HERSTELLUNG EINES OPTISCHEN ELEMENTS UND MEHRSCHICHTIGER KÖRPER MIT OPTISCHEM ELEMENT
PROCÉDÉ POUR LA FABRICATION D'ÉLÉMENT OPTIQUE ET CORPS MULTICOUCHE COMPRENANT ÉLÉMENT OPTIQUE

(30) Priority: 29.10.2010 JP 2010243824
(43) Date of publication of application: 04.09.2013
(73) Proprietor: Tokuyama Corporation, Shunan-shi, Yamaguchi 745-8648 (JP)
(72) Inventor: KINOSHITA, Toru, Shunan-shi Yamaguchi 745-8648 (JP); TAKADA, Kazuya, Shunan-shi Yamaguchi 745-8648 (JP)
(74) Representative: Schlief, Thomas P.
(86) International application number: PCT/JP2011/073831
(87) International publication number: WO 2012/056928

(56) References cited:
- EP-A1- 2 243 866
- WO-A1-2010/033910
- WO-A2-2008/054994
- JP-A- 2009 143 778
- JP-A- 2009 155 141
- JP-A- 2009 190 918
- JP-A- 2010 521 059
- US-A1- 2010 264 460
- LU P ET AL: "Different optical absorption edges in AlN bulk crystals grown in m- and c-orientations", APPLIED PHYSICS LETTERS, AMERICAN INSTITUTE OF PHYSICS, US, vol. 93, no. 13, 3 October 2008 (2008-10-03), pages 131922-131922, XP012111679, ISSN: 0003-6951, DOI: 10.1063/1.2996413

## Description

### TECHNICAL FIELD

The present invention relates to a novel method for manufacturing an optical element and an optical element multilayered body. Particularly, the present invention relates to the method for manufacturing the optical element including steps of, forming an aluminum nitride single crystal layer having excellent optical characteristics on an aluminum nitride seed substrate, forming an optical element layer on said aluminum nitride single crystal layer, and removing said aluminum nitride seed substrate. Also, the present invention relates to an optical element multilayered body including: the aluminum nitride seed substrate, the aluminum nitride single crystal layer having excellent optical characteristic formed on said aluminum nitride seed substrate, and the optical element formed on said aluminum nitride single crystal layer. Said optical element multilayered body is an intermediate product at the manufacturing steps of the optical element, and in the manufacturing steps of the optical element and the transportation, storage of the intermediate product becomes easy, thus it contributes to improve the manufacturing efficiency.

### DESCRIPTION OF THE RELATED ART

A group III nitrides semiconductor including aluminum (Al) has a band structure of direct transition bandgap type in the ultraviolet range corresponding to the wavelength of 200 nm to 360 nm; thus it is possible to manufacture a high efficient ultraviolet light emitting device.

The group III nitrides semiconductor device is, in general, manufactured by allowing the crystal growth of group III nitrides semiconductor thin membrane on the single crystal layer, by a chemical vapor phase deposition method such as metal organic chemical vapor phase deposition method (MOCVD method), molecular beam epitaxy method (MBE method), or halide vapor epitaxy method (HVPE method) or so.

In case of manufacturing said ultraviolet light emitting device, it is difficult to obtain a substrate having good conformity of a lattice constant and a heat expansion coefficient with the group III nitrides semiconductor crystal including Al. Therefore, generally, the group III nitrides semiconductor crystal including Al is formed on a substrate made of different material such as sapphire substrate or silicon carbide substrate. However, when using the substrate made of different material such as sapphire substrate as the seed substrate, since the difference of the lattice constant between the group III nitrides semiconductor crystal layer and the seed substrate is large, a high density dislocation was generated in the group III nitrides semiconductor crystal layer at the boundary between the group III nitrides semiconductor crystal layer and the seed substrate. As a result, there was a problem that the dislocation density in the device layer was also increased.

Therefore, in WO2009/090821 the following method for forming the group III nitrides semiconductor crystal including Al on the seed substrate of the group III nitrides (the substrate of same material) has been proposed. Specifically, first, on a substrate made of different material, the group III nitrides single crystal thin layer including Al and the group III nitrides non-single crystal layer are stacked. Next, the substrate made of different material is removed, and on the exposed said thin layer, the group III nitrides single crystal layer including Al is further stacked. Then, at least the group III nitrides non-single crystal layer including Al portion is removed. This is a method with a free-standing substrate comprising the group III nitrides single crystal layer including Al as the seed substrate. However, in this method wherein the group III nitrides single crystal layer including Al is taken out to form the free-standing substrate, in order to obtain the high quality free-standing substrate, and further the high quality ultraviolet light emitting device, following points needed to be improved. That is, in the above mentioned method, in order to obtain the free-standing substrate of high quality and having excellent strength, the polishing and the cutting or so is needed for taking out; however considering these procedure and the strength of the free-standing substrate, it was necessary to sufficiently thicken the group III nitrides single crystal layer including Al. By making the group III nitrides single crystal layer including Al thicker, the productivity was lowered, and further said single crystal layer itself was easily cracked. Thus in view of such points they needed to be improved.

Also, there is a method of forming the group III nitrides semiconductor crystal including Al on the seed substrate (the substrate made of same material) of the group III nitrides by a physical vapor phase deposition method represented by sublimation method. In this case, as it uses the substrate made of same material, wherein the difference of the lattice constant between the group III nitrides semiconductor crystal layer is small, the dislocation at the boundary between the group III nitrides semiconductor crystal layer and the seed substrate can be suppressed. Also, in general, in the physical vapor phase deposition method, the seed crystal of group III nitrides having low dislocation density is obtained; thus by using such substrate, there is an advantage that the dislocation density in the group III nitrides semiconductor crystal can be reduced, see the article in Applied Physics Express 3 (2010) 072103. However, in general, the seed substrate manufactured by the physical vapor phase deposition method has many impurities and point defects; thus there was a problem that said seed substrate has a significantly large absorption coefficient at the wavelength of 200 nm to 300 nm, see the article in Journal of Applied Physics 103, 073522 (2008). As a result, the ultraviolet light was absorbed by the substrate; hence, it was difficult to manufacture the high efficient optical element, particularly of high efficient ultraviolet LED.

US 2010/0264460 A1 discloses various embodiments of a semiconductor device including an aluminum nitride single-crystal substrate, a pseudomorphic strained layer disposed thereover that comprises at least one of AIN, GaN, InN, or an alloy thereof, and, disposed over the strained layer, a semiconductor layer that is lattice-mismatched to the substrate and substantially relaxed.

WO 2010/033910 A1 describes a light-emitting device, such as a light-emitting diode (LED), which is grown on a substrate including a ZnO-based material. The structure includes a plurality of semiconductor layers and an active layer disposed between the plurality of semiconductor layers. The device is removed from the substrate or the substrate is substantially thinned to improve light emission efficiency of the device.

WO 2008/054994 A2 discloses a III-nitride device on AIN, with optional substrate removal at the end.

### DISCLOSURE OF INVENTION

### PROBLEM TO BE SOLVED BY THE INVENTION

For manufacturing the optical element in high efficiency, the free-standing substrate having low dislocation density and high light transmittance is essential.

The present invention is established in view of such problems and the object is to provide an optical element having the aluminum nitrides single crystal layer with high ultraviolet transmittance and low dislocation density as the free-standing substrate.

### MEANS FOR SOLVING THE PROBLEM

The present invention includes the following points:
(1) A method for manufacturing an optical element including:
   a first step of forming an aluminum nitride single crystal layer by a chemical vapor phase deposition method on an aluminum nitride seed substrate of which an outermost face is an aluminum nitride single crystal face,
   a second step of obtaining an optical element multilayered body by forming an optical element layer on said aluminum nitride single crystal layer,
   a third step of removing said aluminum nitride seed substrate from said optical element multilayered body,
   wherein a thickness of said aluminum nitride single crystal layer in said first step is 50 µm or more, and
   wherein said optical element layer in said second step is an LED element layer.
(2) An optical element multilayered body comprising:
   an aluminum nitride seed substrate of which an outer most face is aluminum nitride single crystal face,
   an aluminum single crystal layer formed on said aluminum nitride seed substrate, and
   an optical element layer formed on said aluminum nitride single crystal layer, wherein a thickness of said aluminum nitride single crystal layer is 50 µm or more, and
   wherein said optical element layer is an LED element layer.
(3) The optical element multilayered body as set forth in (2) wherein an absorption coefficient at 240 nm to 300 nm of said aluminum nitride single crystal layer is 30 cm⁻¹ or less.
(4) The optical element multilayered body as set forth in (2) or (3) wherein the dislocation density of said aluminum nitride single crystal layer is less than 10⁹ cm⁻².

### EFFECTS OF THE INVENTION

According to the present invention, an optical element having an aluminum nitride single crystal layer with high ultraviolet transmittance and low dislocation density as the free-standing substrate can be manufactured. Also, an optical element multilayered body according to the present invention comprises the aluminum nitride seed substrate, which is a substrate made of same material as the substrate of the aluminum nitride single crystal layer and the optical element layer; thus the breakage or so during the transportation is unlikely to occur. Hence, it is easy to handle.

### BRIEF DESCRIPTION OF THE DRAWINGS

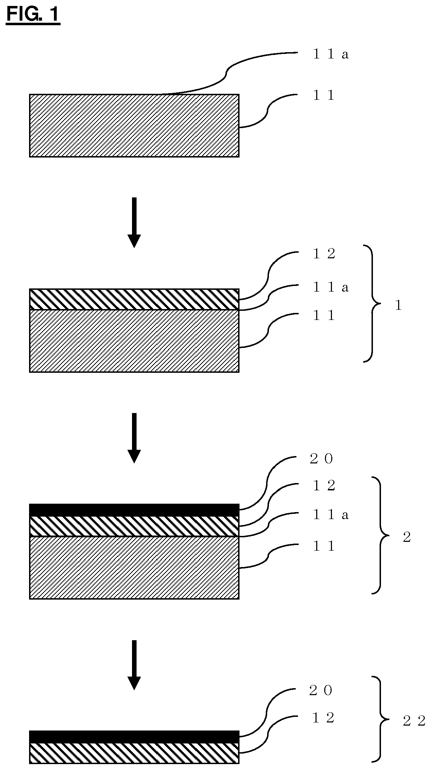

- **Fig. 1**: is a schematic view of one embodiment of the manufacturing steps of the multilayered body of the present invention.

### EMBODIMENTS OF THE INVENTION

The manufacturing method of the optical element of the present invention comprises, as shown in Fig. 1: a first step of forming an aluminum nitride single crystal layer 12 by a chemical vapor phase deposition method on an aluminum nitride seed substrate 11, of which an outermost face is an aluminum nitride single crystal face 11a, a second step of obtaining an optical element multilayered body 2 by forming an optical element layer 20 on said aluminum nitride single crystal layer 12, and a third step of removing said aluminum nitride seed substrate 11 from said optical element multilayered body 2.

### The first step

In the first step of the present invention, the first multilayered body (the free-standing substrate) 1 is obtained by forming the aluminum nitride single crystal layer 12 by the chemical vapor phase deposition method on the aluminum nitride seed substrate 11, which is the substrate made of same material.

The manufacturing method of the aluminum nitride seed substrate 11, of which the outermost face is the aluminum nitride single crystal face 11a, is not particularly limited, and known methods are used. For example, the aluminum nitride seed substrate 11 is made by the chemical vapor phase deposition method, and it may be the aluminum nitride substrate having the aluminum nitride single crystal face at the outermost face or it may the aluminum nitride single crystal substrate made by physical vapor phase deposition method such as sublimation or so.

As one embodiment of the present invention, the aluminum nitride single crystal substrate having the aluminum nitride single crystal face at the outermost face manufactured by the chemical vapor phase deposition method is described below.

As the aluminum nitride seed substrate, of which the outermost face is the aluminum nitride single crystal face, made by the chemical vapor phase deposition, for example, the aluminum nitride single crystal substrate proposed in JP Patent Application Laid Open 2010-89971 may be used. Also, the aluminum nitride based multilayered body including the non-single crystal aluminum nitride layer proposed in WO 2009/090821 and JP Patent Application Laid Open No.2010-10613 may be used.

Among the seed substrates made by such chemical vapor phase deposition methods, by taking into account the productivity of the seed substrate itself and the easiness to carry out the third step, which is described in the following, the aluminum nitride based multilayered body including the non-single crystal aluminum nitride layer is preferably used. Specifically, it is preferable to use the aluminum nitride based multilayered body of which the aluminum nitride single crystal thin layer forming the outermost face is stacked on the non-single crystal aluminum nitride layer made of polycrystal, amorphous or mixture thereof. Further, taking into account the productivity of the aluminum nitride based multilayered body and the crystallinity of the outermost face, the thickness of the aluminum nitride single crystal thin layer forming the outermost face is 10 nm or more and 1.5 µm or less; and it is preferable to use the aluminum nitride based multilayered body wherein the thickness of the non-single crystal aluminum nitride layer is 100 times or more of the aluminum nitride single crystal thin layer.

Such aluminum nitride based multilayered body comprises the amorphous layer. Hence, the ultraviolet ray transmittance is low and unsuitable as the constituting member of the optical element; however, the seed substrate itself is removed in the present invention. Thus, this is not a particular problem for the optical element as the final product. Also, in contrast to the substrate made of different material such as sapphire substrate or so, the multilayered body is made of same aluminum nitride, thus there is an advantage that the difference of the heat expansion coefficient is small. Further, there is an advantage that the amorphous crystal layer can be easily removed at the third step.

It is not particularly limited in regards with the method of forming aluminum nitride single crystal layer 12 by the chemical vapor phase deposition method on the aluminum nitride single crystal face 11a positioned at the outermost face of the above mentioned aluminum nitride seed substrate 11, and known methods are used. As for the chemical vapor phase deposition method, HVPE method or so is generally used.

The aluminum nitride single crystal layer 12 obtained as such has low absorption coefficient of 30 cm⁻¹ or less at wavelength of 240 nm to 300 nm, and the dislocation density can be 10⁹ cm⁻² or less.

Note that the thickness of the aluminum nitride single crystal layer 12 formed at the first step is preferable as it is thinner. However, from the point of making the handling easy during the manufacturing step and suppressing the reduction of the yield caused by the crack or so, it is 50 µm or more; and from the point of practical use, it is further preferably 100 to 300 µm, and particularly preferably 100 to 250 µm.

According to the present invention, even when the thickness of the aluminum nitride single crystal layer 12 is 500 µm or less, more preferably 300 µm or less, and particularly preferably 250 µm or less, the handling during the manufacturing steps can be made easy. This is because the optical element layer 20 is formed on the first multilayered body (free-standing substrate) 1 comprising the aluminum nitride seed substrate 11, which is removed at the end. That is, as it comprises the aluminum nitride seed substrate 11, even when the aluminum nitride single crystal layer 12 is thin, the first multilayered body (free-standing substrate) has sufficient strength. Further, the optical element 22 obtained by the present invention comprises the aluminum nitride single crystal layer 12 having a relatively thin thickness; thus, the ultraviolet ray transmittance can be increased. The ultraviolet ray becomes difficult to transmit as the aluminum nitride single crystal layer 12 becomes thick. However, according to the present invention, said single crystal layer 12 can be made thin, hence it is advantageous.

In the present invention, the thickness of the aluminum nitride seed substrate 11 is not particularly limited, however considering the productivity of the optical element multilayered body described below, the handling characteristics and the easiness at the third step, it is preferably 100 to 500 µm.Note that in case said aluminum nitride based multilayered body is used as said seed substrate, the thickness of said multilayered body preferably satisfies the above mentioned range.

Also, the surface roughness after forming the aluminum nitride single crystal layer 12 is not particularly limited. Note that the aluminum nitride single crystal layer 12 has rough surface immediately after the growth. Thus, in case the performance of the optical element layer formed at the second step is lowered thereby, then it is preferable to sooth the surface by carrying out the surface polishing of the aluminum nitride single crystal layer 12 after finishing the first step. In order to obtain the optical element layer having high quality at the second step, the surface roughness of the aluminum nitride single crystal layer 12 is preferably 5 nm or less in terms of root mean roughness (RMS value) and more preferably 1 nm or less. In case of carrying out this polishing, since the substrate having the seed substrate portion is used, it has sufficient strength, thus the polishing can be carried out easily.

### The second step

In the second step of the present invention, the optical element layer 20 is formed on the first multilayered body (the free-standing substrate) 1 obtained in the first step, thereby the second multilayered body, that is the optical element multilayered body 2, is obtained.

The method for forming the optical element layer 20 on the aluminum nitride single crystal layer 12 is not particularly limited; and known methods are used. Usually, the optical element layer 20 is formed by a chemical vapor phase deposition method such as MOCVD method or so.

As one embodiment of the present invention, the forming of the optical element layer 20 by MOCVD method is described below.

MOCVD method supplies group III metal-organic source material gas and the nitrogen source material gas to the substrate, and allows the growth of the group III nitrides single crystal layer on said substrate. As the source material gas used in the present invention, known source material can be used without any particular limitation depending on the composition of the group III nitrides single crystal layer. Specifically, as for the group III source material gas, the gas of trimethylaluminum, triethylaluminum, trimethylgallium, tri-ethylgallium, or trimethylindium or so may be preferably used. Note that the type of the source material, the used ratio of these group III source materials can be suitably determined in accordance with the composition of the group III nitrides single crystal layer, which is to be grown. Also, as for the nitrogen source gas, the ammonium gas is preferably used. Further, as the impurity source material gas added to control the conductivity, biscyclopentadienylmagnesium as the P-type impurity source material gas, monosilane or tetraethylsilane as N-type impurity source material gas are preferably used. Also, in regards with the MOCVD device used in the present invention, it is not particularly limited as long as it is a structure which allows carrying out the present invention, and known device, or commercially available MOCVD device can be used.

Hereinafter, the example of manufacturing of LED, which is the general optical element, will be described in detail. Also, LED structure described below uses the structure sequentially stacking N-type group III nitrides semiconductor layer, active layer, P-type group III nitrides semiconductor layer, P-type group III nitrides contact layer on the substrate as an example. However, the present invention is not to be limited to the below structure.

First, after placing the first multilayered body 1 (the free-standing substrate 1) obtained in the first step in the MOCVD device, the free-standing substrate 1 is heated at 1050 °C or higher, and preferably 1150 °C or higher; then after carrying out the cleaning of the free-standing substrate surface by maintaining in the hydrogen atmosphere, trimethylaluminum, trimethylgallium, ammonium, monosilane or tetraethylsilane, and the hydrogen and nitrogen or so as the carrier gas of the source material gas is introduced in the MOCVD device, thereby the N-type group III nitrides semiconductor layer is formed.

Also, before forming the above mentioned N-type group III nitrides semiconductor layer, in order to improve the N-type characteristic, the buffer layer may be formed as well. In this case, as the buffer layer, it is preferably the N-type group III nitrides layer comprising the lattice constant same as or in between of the group III nitrides semiconductor layer and the aluminum nitride single crystal layer. Further, the buffer layer may be single layer, or it may be a plurality of multilayered body having different composition.

Next, trimethylaluminum, trimethylgallium, ammonium, and hydrogen and nitrogen or so as the carrier gas of the source material gas is introduced in the MOCVD device; thereby the quantum well structure which becomes the active layer is formed. Here, the quantum well structure is the layered structure wherein the well layer having the thickness of several to several tens of nm, and the barrier layer having larger band gap energy than said well layer are combined; and the band gap energy of the well layer and the thickness of the barrier layer or so may be determined so that desired optical characteristic can be obtained. Also, in addition to the above mentioned source material, in order to improve the optical characteristic, trimethylindium, N-type or P-type impurity source material may be added.

Next, trimethylaluminum, trimethylgallium, ammonium, biscyclopentadienylmagnesium, and hydrogen and nitrogen or so as the carrier gas of the source material gas is introduced in the MOCVD device; thereby, a P-type group III nitrides semiconductor layer is formed. Then, trimethylgallium, ammonium, biscyclopentadienylmagnesium and hydrogen and nitrogen or so as the carrier gas of the source material gas is introduced in the MOCVD device; thereby P-type group III nitrides semiconductor contact layer is formed. Here, the source material supplying ratio, the growth temperature, the ratio (V/III ratio) between the group V element (nitrogen or so) and the group III element or so upon forming the above mentioned group III nitrides semiconductor layer may be determined accordingly so that desired optical characteristic and conductive characteristic can be obtained.

Note that the optical element multilayered body 2 of the present invention is the intermediate product obtained after the above mentioned second step; and it includes the aluminum nitride seed substrate, the aluminum nitride single crystal layer having excellent optical characteristic formed on said aluminum nitride seed substrate, the optical element formed on the aluminum nitride single crystal layer. The optical element multilayered body 2 of the present invention allows easy transportation and storage during the manufacturing step of the optical element, thereby improving the manufacturing efficiency.

### The third step

In the third step of the present invention, the optical element 22 is obtained by removing the aluminum nitride seed substrate from the optical element multilayered body 2 obtained at the second step.

Here, in order to function as the optical element 22 manufactured by the above mentioned process as a device, the processing for forming the element must be carried out such as the etching treatment for exposing the predetermined conductive layer, and the electrode forming treatment to the conductive layer surface or so. The third step of the present invention may be carried out before carrying out the processing step for forming the element, or after carrying out the processing for forming the element. The order of carrying out the third step of the present invention and the processing step for forming the element may be determined accordingly when carrying out the present invention and taking into account of the productivity or handling property or so.

The method for removing the aluminum nitride seed substrate 11 from the optical element multilayered body 2 is not particularly limited, and the known method of the wet etching or so using polishing, reactive ionic etching, and alkaline solution or so can be used; however it is preferable to remove by polishing.

Also, after completing the above mentioned third step, as the means for improving the performance of the optical element, it can be suitably used to form the ridges and grooves on the surface of the aluminum nitride single crystal layer 12 at the side where the aluminum nitride seed substrate 11 has been removed. For example, when the process to form the above mentioned ridges and grooves are used for LED, due to the presence of the ridges and the grooves, the amount of the total reflection decreases at the surface of said substrate. Thus, as a result, the light emitting characteristic of LED can be improved.

The optical element 22 obtained as such is carried out with the treatment for forming the chip or so if needed, and can be used in various purposes of use. The optical element is an LED (light emitting diode).

In one embodiment of the above mentioned present invention, the first multilayered body (the free-standing substrate) 1 is prepared by forming the aluminum nitride single crystal layer 12 by a chemical vapor phase deposition method on the aluminum nitride single crystal seed substrate 11, which is the substrate made of the same material by chemical vapor phase deposition method. Here, as the dislocation density of the aluminum nitride single crystal substrate 11 is low, the lowering of the dislocation density is possible at the optical element layer 20 formed thereon. Further, the aluminum nitride single crystal layer 12 is formed by the chemical vapor phase deposition method, thus low dislocation and high ultraviolet ray transmittance efficiency can be accomplished. Further, the light-extraction efficiency is improved compared to those of conventional one, since the difference of the refraction efficiency between the aluminum nitride single crystal layer 12 and the optical element layer 20 is small.

Note that the present invention is not to be limited to the above described embodiment, and various modifications can be made within the scope of the present invention. For example, the aluminum nitride single crystal seed substrate 11 may be formed by other than the chemical vapor phase deposition method such as by physical vapor phase deposition method of sublimation method or so.

Also, for example, in the above mentioned embodiment, as the optical element according to the present invention, the ultraviolet light emitting element was used.

### EXAMPLE

Hereinafter, the present invention will be described based on further detailed examples. However, the present invention is not to be limited thereto.

### The preparation of the aluminum nitride seed substrate 11

The aluminum nitride seed substrate 11 was prepared by the method described in WO2009/090821. As this aluminum nitride seed substrate 11 the multilayered body, wherein the thickness of the aluminum nitride single crystal thin layer constituting the aluminum nitride single crystal face 11a is 200 nm and the thickness of the non-single crystal aluminum nitride layer (the aluminum nitride polycrystal layer) therebeneath is 300 µm, was used. Also, two of this aluminum nitride seed substrate 11 were prepared in a size of 8 mm square.

### The first step

Two aluminum nitride seed substrates 11 was placed on the susceptor in the HVPE device so that the aluminum nitride single crystal face 11a becomes the outermost face. Then, while flushing in the flow amount of hydrogen of 10 slm and ammonium of 20 sccm, said aluminum nitride seed substrate 11 was heated to 1450 °C, and maintained for 20 minutes to carry out the surface cleaning. Next, 5 sccm aluminum trichloride, which is obtained by reacting metallic aluminum heated to 500 °C and hydrogen chloride gas, 15 sccm of ammonium gas, 1500 sccm of nitrogen as carrier gas, 5000 sccm of hydrogen, were supplied on to the aluminum nitride seed substrate 11, and 150 µm of aluminum nitride single crystal layer 12 was grown.

The surface of the aluminum nitride single crystal layer 12 was observed by a differential interference optical microscope. Thereby, it was confirmed that all of the samples were free of crack at the surface of the aluminum nitride single crystal layer 12. Also, the surface of the aluminum nitride single crystal layer 12 is extremely flat locally; however, on the whole 8 mm square, there were present relatively large ridges and grooves on the entire face of the substrate.

### The polishing and the evaluation of the aluminum nitride single crystal layer 12

Next, the surface of the above mentioned aluminum nitride single crystal layer 12 was polished by CMP (Chemical Mechanical Polishing) polishing so that the RMS value is 1 nm or less; thereby, the first multilayered body 1 (the free-standing substrate 1) was obtained.

Here, in regards with one of the free-standing substrates 1 being made, in order to evaluate the characteristic of the aluminum nitride single crystal layer 12, the aluminum nitride non-crystal layer (the aluminum nitride polycrystal layer) at the back face was removed by the mechanical polishing. Then, by polishing using CMP polishing so that the RMS value was 5 nm or less, the aluminum nitride single crystal layer 12 of which approximately both sides being mirror was taken out. The membrane thickness of the aluminum nitride single crystal layer 12 after the polishing was 100 µm. After planar observation using a transmission electron microscope (the acceleration voltage 300 kV), and the penetration dislocation density of the surface of the aluminum nitride single crystal layer 12 after polishing was measured, it was 3 x 10⁸ cm⁻². Also, when the transmittance of the aluminum nitride single crystal layer 12 was measured by ultraviolet and visible spectrophotometric (UV-2550, made by Shimadzu Corporation), the external transmittance at wave length of 240 nm to 350 nm was 40% or more. Also, when the absorption coefficient was calculated from the above mentioned membrane thickness and the transmittance by setting the refraction ratio of the aluminum nitride single crystal to 2.4, the absorption coefficient at wave length of 240 nm to 350 nm was 20 cm⁻¹ or less.

### The second step

Next, one of the first multilayered bodies 1 (the free-standing substrate 1) was placed on the susceptor in the MOCVD device so that the surface of the aluminum nitride single crystal layer 12 being polished becomes the outermost face. Then, while flushing the hydrogen in a flow mount of 13 slm, the free-standing substrate 1 was heated to 1250 °C and maintained for 10 minutes. Thereby, the surface cleaning was carried out.

Next, the temperature of the free-standing substrate 1 was set to 1200 °C. Then, under the conditions of 25 µmol/min of flow amount of trimethylaluminum, 1 slm of the flow amount of ammonium, the whole flow amount of 10 slm, and the pressure of 50 Torr, the aluminum nitride buffer layer having the thickness of 0.1 µm was formed on the aluminum nitride single crystal layer 12. Next, the substrate temperature on the susceptor was set to 1120 °C, and under the condition of 20 µmol/min of flow amount of trimethylgallium, 35 µmol/min of flow amount of trimethylaluminum, 1.5 slm of the ammonium flow amount, the whole flow amount of 10 slm, and the pressure of 50 Torr, 0.2 µm of Al_{0.7}Ga_{0.3}N buffer layer was formed. Further, other than simultaneously supplying 3 nmol/min of tetraethylsilane, 1.2 µm of N-type Al_{0.7}Ga_{0.3}N layer was formed as same as the buffer layer.

Next, other than setting the flow amount of trimethylgallium to 40µmol/min and the flow amount of trimethylaluminum to 3 µmol/min, 2 nm of Al_{0.7}Ga_{0.3}N well layer was formed as same as the buffer layer. Next, 15 nm of the barrier layer was formed as same as the buffer layer. The three period multiple quantum well layers were formed by repeating the growth of this well layer and the barrier layer for three times.

Next, the flow amount of trimethylgallium was set 15 µmol/min, and other than simultaneously supplying 0.8 µmol/min of biscyclopentadieylmagnesium, 20 nm of P-type Al_{0.8}Ga_{0.2}N layer was formed as same as the buffer layer. Next, under the condition of the flow amount of trimethylgallium of 40 µmol/min, biscyclopentadienylmagenesium of 0.3 µmol/min, the flow amount of ammonium of 2.0 slm, the whole flow amount of 8 slm, and the pressure of 150 Torr, 0.2 µm of P-type GaN contact layer was formed. This substrate was taken out from MOCVD device, and under the nitrogen atmosphere for 20 minutes at 800 °C, the heat treatment was carried out.

Next, by using the ICP etching device, a portion of said substrate was etched until the Si doping Al_{0.7}Ga_{0.3}N layer was exposed; then by vacuum evaporation method, a Ti(20 nm)/AI(100 nm)/Ti(20 nm)/Au(50 nm) electrode was formed on the exposed surface; followed by heat treatment under nitrogen atmosphere for 1 minute at 1000 °C. Next, on the above mentioned P-type GaN contact layer, a Ni(20 nm)/Au(100 nm) electrode was formed by vacuum evaporation method, then carried out with the heat treatment under the nitrogen atmosphere for 5 minutes at 500 °C.

As described hereinabove, on the aluminum nitride single crystal layer 12 of the first multilayered body, the second multilayered body 2 (the optical element multilayered body 2), on which the optical element layer 20 is stacked, was made. When the light emitting characteristic was evaluated from the back face of the element when direct current 10 mA is running in the optical element multilayered body 2 produced as such, a weak signal light emitting peak was confirmed at light emitting wave length of 265 nm.

### The third step

The non-single crystal aluminum nitride layer (aluminum polycrystal layer) of the back face of said optical element multilayered body 2 was removed by polishing, then by CMP polishing, it was polished so that the RMS value was 5 nm or less; thereby the optical element 22 was made. Note that the thickness of this optical element 22 was about 100 µm. When the light emittance was measured for this optical element 22 with the same method as with the optical element multilayered body 2, the single peak light emittance of the light emitting wave length was at 265 nm, and the intensity of the light emitting peak of this optical peak element 22 was confirmed to be 10 times the intensity of the optical element multilayered body 2.

### NUMERICAL REFERENCES

- 2: Second multilayered body (the optical element multilayered body)
- 1: First multilayered body (the free-standing substrate)
- 11: Aluminum nitride seed substrate
- 11a: Aluminum nitride single crystal face
- 12: Aluminum nitride single crystal layer
- 20: Optical element layer
- 22: Optical element

## Claims

1. A method for manufacturing an optical element (22) including, in the following sequence :
a first step of forming an aluminum nitride single crystal layer (12) by a chemical vapor phase deposition method on an aluminum nitride seed substrate (11) made of aluminum nitride of which an outermost face is an aluminum nitride single crystal face (11a),
a second step of obtaining an optical element multilayered body (2) by forming an optical element layer (20) on said aluminum nitride single crystal layer (12), and
a third step of removing said aluminum nitride seed substrate (11) from said optical element multilayered body (2),
wherein a thickness of said aluminum nitride single crystal layer (12) in said first step is 50 µm or more, and
wherein said optical element layer (20) in said second step is an LED element layer.

2. The method for manufacturing the optical element (22) as set forth in claim 1, wherein
the LED element layer in said second step is formed by sequentially stacking, on the aluminum nitride single crystal layer (12), N-type group III nitrides semiconductor layer, active layer, P-type group III nitrides semiconductor layer and P-type group III nitrides contact layer.

3. An optical element multilayered body (2) comprising:
an aluminum nitride seed substrate (11) made of aluminum nitride of which an outermost face is an aluminum nitride single crystal face (11a),
an aluminum nitride single crystal layer (12) formed on said aluminum nitride seed substrate (11), and
an optical element layer (20) formed on said aluminum nitride single crystal layer (12),
wherein a thickness of said aluminum nitride single crystal layer (12) is 50 µm or more, and
wherein said optical element layer (20) is an LED element layer.

4. The optical element multilayered body (2) as set forth in claim 3, wherein
the LED element layer has a structure sequentially stacking, on the aluminum nitride single crystal layer (12), N-type group III nitrides semiconductor layer, active layer, P-type group III nitrides semiconductor layer and P-type group III nitrides contact layer.

5. The optical element multilayered body (2) as set forth in claim 3 or 4, wherein an absorption coefficient at 240 nm to 300 nm of said aluminum nitride single crystal layer (12) is 30 cm⁻¹ or less.

6. The optical element multilayered body (2) as set forth in any of claims 3 to 5, wherein the dislocation density of said aluminum nitride single crystal layer (12) is less than 10⁹ cm⁻².

## Patentansprüche

1. Verfahren zum Herstellen eines optischen Elements (22), enthaltend in der folgenden Abfolge:
einen ersten Schritt des Ausbildens einer Aluminiumnitrid-Einkristallschicht (12) mit einem chemischen Gasphasenabscheidungsverfahren auf einem Aluminiumnitrid-Ausgangssubstrat (11), bestehend aus Aluminiumnitrid, dessen äußerste Fläche eine Aluminiumnitrid-Einkristallfläche (11a) ist,
einen zweiten Schritt des Erhaltens eines Mehrschicht-Körpers (2) des optischen Elements durch ein Ausbilden einer Schicht (20) des optischen Elements auf der Aluminiumnitrid-Einkristallschicht (12), und
einen dritten Schritt des Entfernens des Aluminiumnitrid-Ausgangssubstrats (11) von dem Mehrschicht-Körper (2) des optischen Elements,
wobei eine Dicke der Aluminiumnitrid-Einkristallschicht (12) in dem ersten Schritt 50 µm oder mehr beträgt, und
wobei die Schicht (20) des optischen Elements in dem zweiten Schritt eine LED-Elementschicht ist.

2. Verfahren zum Herstellen des optischen Elements (22) nach Anspruch 1, wobei
die LED-Elementschicht in dem zweiten Schritt ausgebildet wird durch ein Aufeinanderschichten auf der Aluminiumnitrid-Einkristallschicht (12) einer N-Halbleiterschicht aus Gruppe-III-Nitriden, einer aktiven Schicht, einer P-Halbleiterschicht aus Gruppe-III-Nitriden und einer P-Kontaktschicht aus Gruppe-III-Nitriden.

3. Mehrschicht-Körper (2) eines optischen Elements, umfassend:
ein Aluminiumnitrid-Ausgangssubstrat (11), bestehend aus Aluminiumnitrid, dessen äußerste Fläche eine Aluminiumnitrid-Einkristallfläche (11a) ist,
eine Aluminiumnitrid-Einkristallschicht (12), ausgebildet auf dem Aluminiumnitrid-Ausgangssubstrat (11), und
eine Schicht (20) des optischen Elements, ausgebildet auf der Aluminiumnitrid-Einkristallschicht (12),
wobei eine Dicke der Aluminiumnitrid-Einkristallschicht (12) 50 µm oder mehr beträgt, und
wobei die Schicht (20) des optischen Elements eine LED-Elementschicht ist.

4. Mehrschicht-Körper (2) eines optischen Elements nach Anspruch 3, wobei
die LED-Elementschicht einen Aufbau aufweist, in dem auf der Aluminiumnitrid-Einkristallschicht (12) eine N-Halbleiterschicht aus Gruppe-III-Nitriden, eine aktive Schicht, eine P-Halbleiterschicht aus Gruppe-III-Nitriden und eine P-Kontaktschicht aus Gruppe-III-Nitriden aufeinandergeschichtet sind.

5. Mehrschicht-Körper (2) eines optischen Elements nach Anspruch 3 oder 4, wobei ein Absorptionskoeffizient bei 240 nm bis 300 nm der Aluminiumnitrid-Einkristallschicht (12) 30 cm⁻¹ oder weniger beträgt.

6. Mehrschicht-Körper (2) eines optischen Elements nach einem beliebigen der Ansprüche 3 bis 5, wobei die Versetzungsdichte der Aluminiumnitrid-Einkristallschicht (12) weniger als 10⁹ cm⁻² beträgt.

## Revendications

1. Procédé pour fabriquer un élément optique (22), comprenant, dans l'ordre suivant :
une première étape consistant à former une couche monocristalline (12) de nitrure d'aluminium par un procédé de dépôt chimique en phase vapeur sur un substrat (11) de germes de nitrure d'aluminium composé de nitrure d'aluminium dont une face la plus externe est une face monocristalline (11a) de nitrure d'aluminium,
une seconde étape consistant à obtenir un corps multicouche (2) d'élément optique en formant une couche (20) d'élément optique sur ladite couche monocristalline (12) de nitrure d'aluminium, et
une troisième étape consistant à retirer ledit substrat (11) de germes de nitrure d'aluminium depuis ledit corps multicouche (2) d'élément optique,
dans lequel une épaisseur de ladite couche monocristalline (12) de nitrure d'aluminium dans ladite première étape est de 50 µm ou plus, et
dans lequel ladite couche (20) d'élément optique dans ladite seconde étape est une couche d'élément à DEL.

2. Procédé pour fabriquer l'élément optique (22) selon la revendication 1, dans lequel
la couche d'élément à DEL dans ladite seconde étape est formée par empilement séquentiel, sur la couche monocristalline (12) de nitrure d'aluminium, d'une couche semi-conductrice de nitrures du groupe III de type N, d'une couche active, d'une couche semi-conductrice de nitrures du groupe III de type P et d'une couche de contact de nitrures du groupe III de type P.

3. Corps multicouche (2) d'élément optique, comprenant :
un substrat (11) de germes de nitrure d'aluminium composé de nitrure d'aluminium dont une face la plus externe est une face monocristalline (11a) de nitrure d'aluminium,
une couche monocristalline (12) de nitrure d'aluminium formée sur ledit substrat (11) de germes de nitrure d'aluminium, et
une couche (20) d'élément optique formée sur ladite couche monocristalline (12) de nitrure d'aluminium,
dans lequel une épaisseur de ladite couche monocristalline (12) de nitrure d'aluminium est de 50 µm ou plus, et
dans lequel ladite couche (20) d'élément optique est une couche d'élément à DEL.

4. Corps multicouche (2) d'élément optique selon la revendication 3, dans lequel
la couche d'élément à DEL a une structure à empilement séquentiel, sur la couche monocristalline (12) de nitrure d'aluminium, d'une couche semi-conductrice de nitrures du groupe III de type N, d'une couche active, d'une couche semi-conductrice de nitrures du groupe III de type P et d'une couche de contact de nitrures du groupe III de type P.

5. Corps multicouche (2) d'élément optique selon la revendication 3 ou 4, dans lequel un coefficient d'absorption à 240 nm à 300 nm de ladite couche monocristalline (12) de nitrure d'aluminium est de 30 cm⁻¹ ou moins.

6. Corps multicouche (2) d'élément optique selon l'une quelconque des revendications 3 à 5, dans lequel la densité de dislocations de ladite couche monocristalline (12) de nitrure d'aluminium est inférieure à 10⁹ cm⁻².
